# EUROPEAN PATENT APPLICATION

(11) **EP 4 597 239 A1**
(43) Date of publication of application: **06.08.2025**
(21) Application number: 23876684.4
(22) Date of filing: 10.10.2023
(51) Int. Cl.: G05B 19/042

(54) **SIGNAL CONTROL CIRCUIT AND METHOD, AND GENERATION APPARATUS, DOCKING STATION, AUTONOMOUS OPERATION SYSTEM AND STORAGE MEDIUM**

(30) Priority: 13.10.2022 CN 202222695830 U; 13.10.2022 CN 202211252963; 20.03.2023 CN 202320608998 U
(71) Applicant: Zhejiang Sunseeker Industrial Co., Ltd., Jinhua, Zhejiang 321000 (CN)
(72) Inventor: WANG, Zhicheng, Jinhua, Zhejiang 321000 (CN); LIU, Fangshi, Jinhua, Zhejiang 321000 (CN)
(74) Representative: Manna, Sara
(86) International application number: PCT/CN2023/123715
(87) International publication number: WO 2024/078482

(57) **Abstract**

Disclosed in an embodiment of the present disclosure are a signal control circuit, a signal control method, a computer-readable storage medium, a signal generation apparatus, a docking station, and an autonomous operation system. The signal control circuit is configured to control the generation of a pulse in a boundary line loop and includes a boundary line; a control module is configured to be connected with the boundary line and control a frequency of the pulse according to a state of the boundary line loop. Therefore, the problem that sparks are easy to generate when the boundary line is connected is solved.

## Description

### TECHNICAL FIELD

The present disclosure relates to the field of intelligent robots, and in particular, to a signal control circuit and a control method for an autonomous operation system, and further relates to a signal generation apparatus, a docking station, and an autonomous operation system including the signal control circuit described above, and a storage medium storing a computer program that can implement the control method described above when executed.

### BACKGROUND

Many existing robots, such as intelligent lawn mowers, are designed to work in a working area defined by boundary lines that are configured as metal wires forming a closed loop. Generally, a docking station that is docked with an intelligent lawn mower is provided with a signal generation apparatus, and a boundary line is led out from the signal generation apparatus, laid along the corresponding working boundary of the intelligent lawn mower, and finally returned to the signal generation apparatus to enclose a working area for the smart mower. The signal generation apparatus controls the pulse signal transmission of the boundary line by means of the opening and closing of an electronic switch. When a user connects the boundary line, for example, when connects the boundary line with a wiring terminal of a charging station or connects two broken boundary line segments, in the case where the charging station is in a power-on state, if the electronic switch happens to be in an open state, the large current at the moment of connection will generate an arc. The electronic switch of the charging station is usually on and off at a high frequency, which leads to a high probability that an arc may be generated by the user when connecting the boundary line under the above circumstances. The arc will not only shock customers, but also cause danger when there are flammable and explosive objects nearby; moreover, the arc also has a great destructive effect on the contact.

### SUMMARY

The technical problem mainly solved by the present disclosure is to provide a signal control circuit which is not easy to generate an arc when a boundary line is connected. In order to solve the above technical problem, the present disclosure provides a signal control circuit configured to control the generation of a pulse in a boundary line loop, including: a boundary line; and a control module, configured to be connected with the boundary line, and to control a frequency of the pulse according to a state of the boundary line loop.

As a specific embodiment of the present disclosure, the signal control circuit further includes a state information acquisition module configured to be connected with the boundary line to obtain state information of the boundary line loop; wherein the control module is configured to be connected with the state information acquisition module, and to control the frequency of the pulse according to the state information of the boundary line loop.

As a specific embodiment of the present disclosure, when the boundary line loop is in a first state, the control module controls the generation of a pulse with a first frequency in the boundary line loop; when the boundary line loop is in a second state, the control module controls the generation of a pulse with a second frequency in the boundary line loop.

As a specific embodiment of the present disclosure, the first state is an on state, and the second state is an open state; the first frequency is greater than the second frequency.

As a specific embodiment of the present disclosure, the first frequency is not less than 50 Hz; the second frequency is less than 50 Hz; optionally, the first frequency is 60 Hz to 100 Hz, and the second frequency is 0.3 Hz to 30 Hz; further optionally, the first frequency is 60 Hz to 70 Hz, and the second frequency is 0.5 Hz to 1.5 Hz.

As a specific embodiment of the present disclosure, a wiring assembly is arranged on the boundary line loop, and the wiring assembly includes a wiring base and a diode; the boundary line is connected with the wiring assembly.

As a specific embodiment of the present disclosure, the control module includes a switch module and a control unit, the switch module being arranged on the boundary line loop; when the switch module is turned on, the boundary line loop is in the on state; when the switch module is turned off, the boundary line loop is in the open state; the control unit is connected with the switch module and configured to control the on-off of the switch module, and the control unit is configured to control an on-off frequency of the switch module according to the state of the boundary line loop.

As a specific embodiment of the present disclosure, the switch module is configured to include an electronic switch, the electronic switch including a field effect transistor. As a specific embodiment of the present disclosure, the switch module further includes a first switch circuit, and the electronic switch is connected with the control unit through the first switch circuit.

As a specific embodiment of the present disclosure, the first switch circuit includes a switch unit, a control terminal of the switch unit being connected with the control unit, an input terminal of the switch unit being connected with a power chip, and meanwhile, the input terminal of the switch unit being connected with a control terminal of the electronic switch, and an output terminal of the switch unit being grounded.

As a specific embodiment of the present disclosure, the switch unit comprises a triode Q2; the switch unit is configured to enable the triode Q2 to be in an off state and the electronic switch to be turned on when the control unit sends out a first level signal; and the transistor Q2 to be in the on state and the electronic switch to be turned off when the control unit sends out a second level signal. Optionally, the first level signal is a low level signal, and the second level signal is a high level signal.

As a specific embodiment of the present disclosure, the first switch circuit further includes a voltage limiting unit, a control terminal of the voltage limiting unit being connected with an output terminal of the electronic switch, an input terminal of the voltage limiting unit being connected with a control terminal of the electronic switch, and an output terminal of the voltage limiting unit being grounded. Optionally, the voltage limiting unit includes a triode Q1.

As a specific embodiment of the present disclosure, the first switch circuit further includes a filter capacitor C18, a first terminal of the filter capacitor C18 being connected with a control terminal of the electronic switch, and a second terminal of the filter capacitor C18 being connected with an output terminal of the electronic switch through a resistor R22.

As a specific embodiment of the present disclosure, the first switch circuit further includes a voltage reduction unit, an input terminal of the voltage reduction unit being connected with a power chip, and an output terminal of the voltage reduction unit being connected with a control terminal of the electronic switch.

As a specific embodiment of the present disclosure, the voltage reduction unit includes a diode D6 and a capacitor C16, a first terminal of the capacitor C16 being connected with a cathode of the diode D6, and a second terminal of the capacitor C16 being grounded.

As a specific embodiment of the present disclosure, the switch module is configured to include a relay.

As a specific embodiment of the present disclosure, the state information acquisition module is configured to include a sampling circuit configured to detect a characteristic value of a current flowing through the boundary line loop; wherein, a first terminal of the boundary line is connected with an external power supply, a second terminal of the boundary line is connected with an input terminal of the switch module, a control terminal of the switch module is connected with the control unit, an output terminal of the switch module is connected with an input terminal of the sampling circuit, a signal terminal of the sampling circuit is connected with the control unit, and an output terminal of the sampling circuit is grounded.

As a specific embodiment of the present disclosure, the sampling circuit includes a current sampling resistor, a first terminal of the current sampling resistor being connected with the input terminal of the sampling circuit, and a second terminal of the current sampling resistor being grounded.

As a specific embodiment of the present disclosure, the sampling circuit further includes a first filter, an input terminal of the first filter being connected with the first terminal of the current sampling resistor, and an output terminal of the first filter being connected with the control unit.

As a specific embodiment of the present disclosure, the sampling circuit further includes a follower unit, an input terminal of the follower unit being connected with the output terminal of the first filter, and an output terminal of the follower unit being connected with the control unit.

As a specific embodiment of the present disclosure, the sampling circuit further includes an amplifier, the first terminal of the current sampling resistor being connected with the input terminal of the first filter through the amplifier.

As a specific embodiment of the present disclosure, the sampling circuit further includes a second filter, the first terminal of the current sampling resistor being connected with an input terminal of the amplifier through the second filter.

In order to solve the above technical problem, the present disclosure further provides a signal control method, which includes acquiring a state of a boundary line loop; and controlling a frequency of a boundary signal according to the state of the boundary line loop.

As a specific embodiment of the present disclosure, when the boundary line loop is in a first state, the frequency of the boundary signal is controlled to be a first frequency; and when the boundary line loop is in a second state, the frequency of the boundary signal is controlled to be a second frequency.

As a specific embodiment of the present disclosure, the first state is an on state, and the second state is an open state; the first frequency is greater than the second frequency.

In order to solve the above technical problem, the present disclosure further provides a signal control circuit configured to control a frequency of a pulse in a boundary line loop, which includes: a boundary line; and a control module configured to be connected with the boundary line; wherein, the control module is further configured to include a memory and a processor, the memory storing a computer program executable on the processor; the processor may implement the signal control method described above when executing the computer program.

In order to solve the above technical problem, the present disclosure further provides a computer-readable storage medium having a computer program stored thereon. The computer program, when executed by a processor, may implement the signal control method described above.

In order to solve the above technical problem, the present disclosure further provides a signal generation apparatus configured to generate a boundary signal, including the signal control circuit described above.

In order to solve the above technical problem, the present disclosure further provides a docking station configured to be able to supply energy to an autonomous operation device parked at the docking station, including the signal generation apparatus described above.

In order to solve the above technical problem, the present disclosure further provides an autonomous operation system, which includes an autonomous operation device, and further includes the signal generation apparatus described above or includes the docking station described above.

### BRIEF DESCRIPTION OF THE DRAWINGS

For clearer descriptions of the technical solutions according to the embodiments of the present disclosure, the drawings required to be used in the description of the embodiments of the present disclosure are briefly introduced below. It is apparent that the drawings in the description below are only some embodiments of the present disclosure, and for those of ordinary skill in the art, other drawings may be obtained from the contents of the embodiments of the present disclosure and these drawings without creative efforts.
FIG. 1 is a schematic diagram of an autonomous operation system according to an embodiment of the present disclosure.
FIG. 2 is a schematic diagram of a signal control circuit according to an embodiment of the present disclosure.
FIG. 3 is a schematic diagram of a switch module according to an embodiment of the present disclosure.
FIG. 4 is a circuit diagram of a switch module according to an embodiment of the present disclosure.
FIG. 5 is a schematic diagram of a state information acquisition module according to an embodiment of the present disclosure.
FIG. 6 is a schematic diagram of a sampling circuit according to an embodiment of the present disclosure.
FIG. 7 is a flowchart of a signal control method according to an embodiment of the present disclosure.

### DETAILED DESCRIPTION

The present disclosure will be further described in detail below with reference to the drawings and embodiments. It should be understood that the specific embodiments described herein are merely illustrative of the present disclosure and are not to be construed as limiting the present disclosure. In addition, it should be noted that, for convenience of description, only the portions related to the present disclosure are shown in the accompanying drawings.

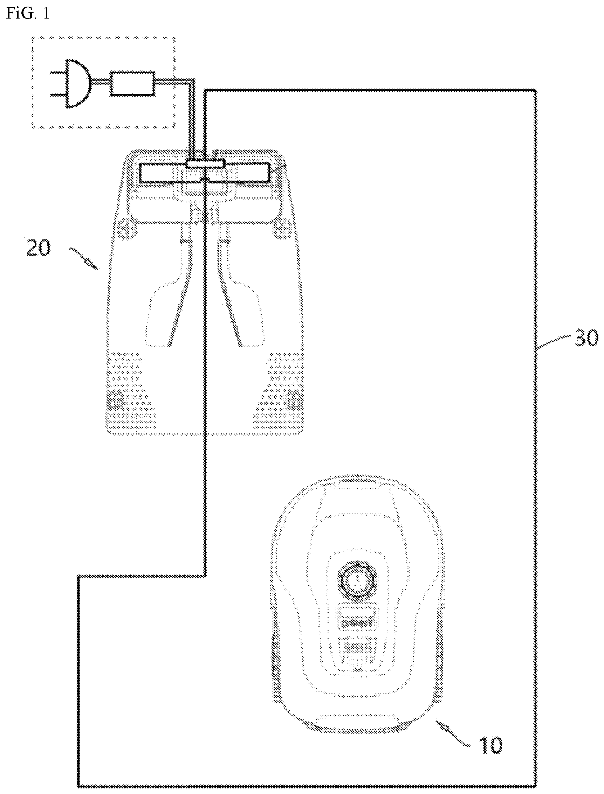

Referring to FIG. 1, this embodiment provides an autonomous operation system including an autonomous operation device 10, a docking station 20, and a boundary 30.

The autonomous operation device 10 is, in particular, a robot that can autonomously move in a preset area and perform a specific operation, typically such as an intelligent sweeper/vacuum cleaner performing a cleaning operation, or an intelligent lawn mower performing a lawn mowing operation. The specific operation particularly refers to an operation for processing a work surface and changing a state of the work surface. The present disclosure is described in detail by taking an intelligent lawn mower as an example. The autonomous operation device 10 can autonomously walk on the surface of a working area, and in particular, as an intelligent lawn mower, can autonomously perform a lawn mowing operation on the ground. The autonomous operation device 10 at least includes a main body mechanism, a movement mechanism, a working mechanism, an energy module, a detection module, an interaction module, a control module, and the like.

The main body mechanism generally includes a chassis and a housing. The chassis is configured to mount and accommodate functional mechanisms and functional modules, such as the movement mechanism, the working mechanism, the energy module, the detection module, the interaction module, and the control module. The housing is generally configured to at least partially cover the chassis, primarily to enhance the aesthetics and recognizability of the autonomous operation device 10. In this embodiment, the housing is configured to be capable of translation and/or rotation relative to the chassis under an external force. In cooperation with a suitable detection module, such as a Hall sensor, the housing can further serve to detect events like collisions and lifting.

The movement mechanism is configured to support the main body mechanism on the ground and drive the main body mechanism to move on the ground, and generally includes a wheeled movement mechanism, a tracked or semi-tracked movement mechanism, a walking movement mechanism, and the like. In this embodiment, the movement mechanism is a wheeled movement mechanism, which includes at least one driving wheel and at least one walking prime mover. The walking prime mover is preferably a motor, and in other embodiments, the walking prime mover may be an internal combustion engine or a machine that uses other types of energy sources to generate power. In this embodiment, the movement mechanism includes a left driving wheel, a left walking prime mover that drives the left driving wheel, a right driving wheel, and a right walking prime mover that drives the right driving wheel. In this embodiment, the linear travel of the autonomous operation device is achieved by the rotation of the left and right driving wheels at the same speed in the same direction, and the steering travel is achieved by the rotation of the left and right driving wheels in the same direction at different speeds or in opposite directions. In other embodiments, the movement mechanism may further include a steering mechanism independent of the driving wheels and a steering prime mover independent of the walking prime mover. In this embodiment, the movement mechanism further includes at least one driven wheel, typically configured as a universal wheel, and the driving wheel and the driven wheel are respectively located at the front and rear ends of the autonomous operation device.

The working mechanism is configured to perform a specific operation task and includes a working piece and a working prime mover that drives the working piece to operate. For example, for an intelligent sweeper/vacuum cleaner, the working piece includes a roller brush, a dust suction pipe, a dust collection chamber, and the like. For an intelligent lawn mower, the working piece includes a cutting blade or a cutting cutterhead, and further includes other components for optimizing or adjusting a mowing effect, such as a height adjustment mechanism for adjusting a mowing height. **In** this embodiment, the working prime mover is configured as a motor, and may be configured, in other embodiments, as an internal combustion engine or a machine that uses other types of energy sources to generate power. In some other embodiments, the working prime mover and the walking prime mover are configured as the same prime mover.

The energy module is configured to provide energy for various work of the autonomous operation device 10. In this embodiment, the energy module includes a battery and a charging connection structure, wherein the battery is optionally a rechargeable battery; and the charging connection structure is configured as a charging electrode that may be exposed outside the autonomous operation device. The detection module is configured as at least one sensor configured to sense an environmental parameter of the position of the autonomous operation device 10 and/or a working parameter of the detection module. In some embodiments, the detection module may include sensors related to the definition of the working area, such as magnetic induction, collision, ultrasonic, infrared, radio, and various types. The types of sensors are adapted to the position and number of the corresponding signal generation apparatuses. The detection module may also include positioning navigation related sensors such as satellite positioning apparatuses, visual positioning apparatuses, laser positioning apparatuses, electronic compasses, acceleration sensors, odometers, angle sensors, and geomagnetic sensors. The detection module may further include sensors related to its own working safety, such as an obstacle sensor, a lifting sensor, and a battery pack temperature sensor. The detection module may further include sensors related to an external environment, such as an ambient temperature sensor, an ambient humidity sensor, a light sensor, and a rain sensor.

The interaction module is configured at least to receive control instruction information inputted by a user, transmit information requiring user perception, and communicate with other systems or devices to transmit and receive information. In this embodiment, the interaction module includes an input apparatus arranged on the autonomous operation device 10 for receiving control instruction information inputted by a user, typically such as a control panel and an emergency stop key. The interaction module further includes at least one of a display screen, an indicator light, or a buzzer arranged on the autonomous operation device 10, enabling a user to perceive information through light or sound. In other embodiments, the interaction module includes a communication module arranged on the autonomous operation device 10 and a terminal device independent from the autonomous operation device 10, and the terminal device is, for example, a mobile phone, a computer, and a network server. User control instruction information or other information may be inputted on the terminal device and reach the autonomous operation device 10 via a wired or wireless communication module.

The control module typically includes at least one processor and at least one nonvolatile memory. The memory stores a pre-written computer program or an instruction set, and the processor, according to the computer program or the instruction set, controls the performance of movements, work, and the like of the autonomous operation device 10. For example, the control module can also control and adjust the corresponding actions of the autonomous operation device 10 and modify parameters in the memory in response to a signal of the detection module and/or a user control instruction.

The boundary 30 is configured to limit the working area of the robotic system and generally includes an outer boundary and an inner boundary. The autonomous operation device 10 is limited to move and work within the outer boundary, outside the inner boundary, or between the outer boundary and the inner boundary. The boundary may be solid, for example, a wall, fence, or railing; the boundary may also be virtual, for example, a virtual boundary signal emitted by the signal generation apparatus, which is usually an electromagnetic signal or an optical signal, or a virtual boundary set in an electronic map, for example formed by two-dimensional or three-dimensional coordinates, for an autonomous operation device 10 provided with a positioning apparatus (such as a GNSS). In this embodiment, the boundary 30 is configured as a closed energized boundary line that is electrically connected with the signal generation apparatus which is typically arranged in the docking station 20.

The docking station 20 is usually configured on the boundary 30 or in the boundary 30 for the autonomous operation device 10 to park, and is particularly capable of supplying energy to the autonomous operation device 10 parked at the docking station.

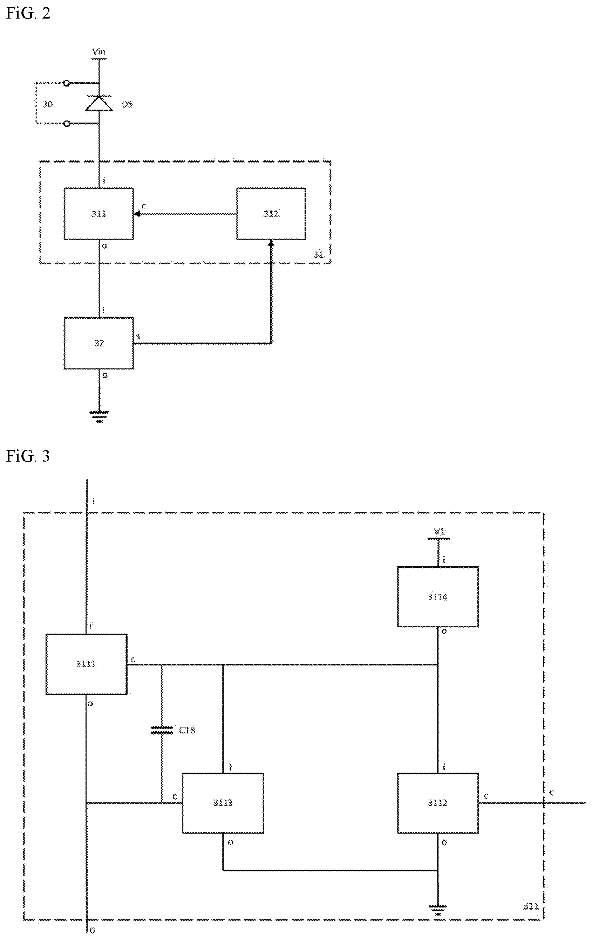

Referring to FIG. 2, an embodiment of the present disclosure provides a signal generation apparatus, which includes a signal control circuit; the signal control circuit is configured to control the generation of a pulse in a boundary line loop and includes a boundary line 30 and a control module. The control module 31 is configured to be connected with the boundary line 30, and to control a frequency of the pulse according to a state of the boundary line loop. For example, the signal control circuit further includes a state information acquisition module configured to be connected with the boundary line to obtain state information of the boundary line loop; wherein the control module is configured to be connected with the state information acquisition module, and to control the frequency of the pulse according to the state information of the boundary line loop.

In this embodiment, a wiring assembly is arranged on the boundary line loop, and the wiring assembly includes a wiring base and a diode D5. The wiring base is mounted on the docking station, and the wiring base includes two wiring plates, and each wiring plate includes a first terminal and a second terminal opposite to each other, wherein the first terminal exposes outside the docking station, and the second terminal inserts in the docking station. The first terminals of the two wiring plates are electrically connected with two ends of the boundary line, respectively, and the second terminals of the two wiring plates are electrically connected with two ends of the diode D5, respectively. The diode D5 plays a role of freewheeling in the circuit. A cathode of the diode D5 is connected with an external power supply Vin, and an anode of the diode D5 is connected with a control module 31. For example, the diode D5 is a Schottky diode.

For example, the control module 31 includes a switch module 311 and a control unit 312, the switch module 311 being arranged on the boundary line loop, when the switch module 311 is turned on, the boundary line loop is in the on state; when the switch module 311 is turned off, the boundary line loop is in the open state; the control unit 312 is electrically connected with the switch module 311, and controls the on-off of the switch module 311 to generate a pulse in the boundary line loop; the control unit 312 is configured to be connected with the state information acquisition module 32, and to control an on-off frequency of the switch module 311 according to the state of the boundary line loop. In this embodiment, the control unit 312 is configured to include a single chip microcomputer.

In this embodiment, the switch module 311 is configured to include an electronic switch 3111, and referring to FIG. 3 to FIG. 4, an input terminal 3111i of the electronic switch is connected with an anode of the diode D5, an output terminal 3111o of the electronic switch is connected with an input terminal 32i of the state information acquisition module, and a control terminal 3111c of the electronic switch is connected with the control unit 312. The electronic switch includes a field effect transistor Q3; the electronic switch is configured to be turned on when a gate voltage of the field effect transistor Q3 reaches a certain voltage threshold. When the control unit sends out a first level signal, the electronic switch is turned on; when the control unit sends out a second level signal, the electronic switch is turned off. Specifically, the first level signal is a low level signal, and the second level signal is a high level signal.

For example, the electronic switch further includes a diode D3; a source of the field effect transistor Q3 is connected with an anode of the diode D3, a drain of the field effect transistor Q3 is connected with a cathode of the diode D3, a gate of the field effect transistor Q3 is connected with the control unit 312, the cathode of the diode D3 is connected with an input terminal 311i of the switch module, the anode of the diode D3 is connected with an output terminal 311o of the switch module, and the diode D3 is configured as a body diode and configured to prevent the field effect transistor Q3 from being burnt out when the power supply voltage is too high.

For example, the electronic switch is configured in parallel with a diode TVS1, and the diode TVS1 is in parallel with a field effect transistor Q3 to protect the field effect transistor Q3. Specifically, the diode TVS1 is a transient voltage suppression diode. A cathode of the diode TVS1 is connected with the drain of the field effect transistor Q3, and an anode of the diode TVS1 is connected with the source of the field effect transistor Q3. Specifically, a resistor R16 is connected in parallel between the source and the gate of the field effect transistor Q3, and plays the roles of voltage division and current leakage in the circuit.

In this embodiment, the switch module 311 is configured to further include a first switch circuit, and the electronic switch 3111 is connected with the control unit 312 through the first switch circuit. The first switch circuit includes a switch unit 3112, a control terminal 3121c of the switch unit being connected with the control unit 312, an input terminal 3112i of the switch unit being connected with a power chip V1, and meanwhile, the input terminal 3112i of the switch unit being connected with a control terminal 3111c of the electronic switch, and an output terminal 3112o of the switch unit being grounded.

Specifically, the first switch circuit includes a triode Q2. A base of the triode Q2 is connected with the control unit 312, a collector of the triode Q2 is connected with the power chip V1 through a resistor R11, and meanwhile, the collector of the triode Q2 is connected with the control terminal 3111c of the electronic switch through a resistor R13, and an emitter of the triode Q2 is grounded. The first switch circuit is configured to enable the triode Q2 to switch between the on state and the off state when the level of the control terminal 3112c of the switch unit changes, such that the gate voltage of the field effect transistor Q3 changes, thereby controlling the on and off of the electronic switch. When the control unit 312 sends out a first level signal, the triode Q2 is in an off state, and at this time, the gate voltage of the field effect transistor Q3 reaches a certain voltage threshold, and the electronic switch is turned on; when the control unit 312 sends out a second level signal, the triode Q2 is in an on state, and at this time, the gate voltage of the field effect transistor Q3 cannot reach a certain voltage threshold, and the electronic switch is turned off. Specifically, the first level signal is a low level signal, and the second level signal is a high level signal.

In this embodiment, the first switch circuit further includes a voltage limiting unit 3113, a control terminal 3113c of the voltage limiting unit being connected with the output terminal 3111o of the electronic switch, an input terminal 3113i of the voltage limiting unit being connected with the control terminal 3111c of the electronic switch, and an output terminal 3113o of the voltage limiting unit being grounded. Further, the voltage limiting unit 3113 includes a triode Q1, a base of the triode Q1 being connected with the output terminal 3111o of the electronic switch through a resistor R22, a collector of the triode Q1 being connected with the control terminal 3111c of the electronic switch, and an emitter of the triode Q1 being grounded.

In this embodiment, the first switch circuit further includes a filter capacitor C18, a first terminal of the filter capacitor C18 being connected with the control terminal 3111c of the electronic switch, and a second terminal of the filter capacitor C18 being connected with the output terminal 3111o of the electronic switch through the resistor R22.

In this embodiment, the first switch circuit further includes a voltage reduction unit 3114, an input terminal 3114i of the voltage reduction unit being connected with the power chip V1, and an output terminal 3114o of the voltage reduction unit being connected with the control terminal 3111c of the electronic switch.

For example, the voltage reduction unit 3114 includes a diode D6 and a capacitor C16, the diode D6 being connected in series with the capacitor C16, wherein an anode of the diode D6 is connected with the power chip V1, a cathode of the diode D6 is connected with the output terminal 3111o of the electronic switch through a resistor R13, a first terminal of a capacitor C11 is connected with the cathode of the diode D6, and a second terminal of the capacitor C16 is grounded.

In other embodiments, the switch module 31 is configured to include a relay.

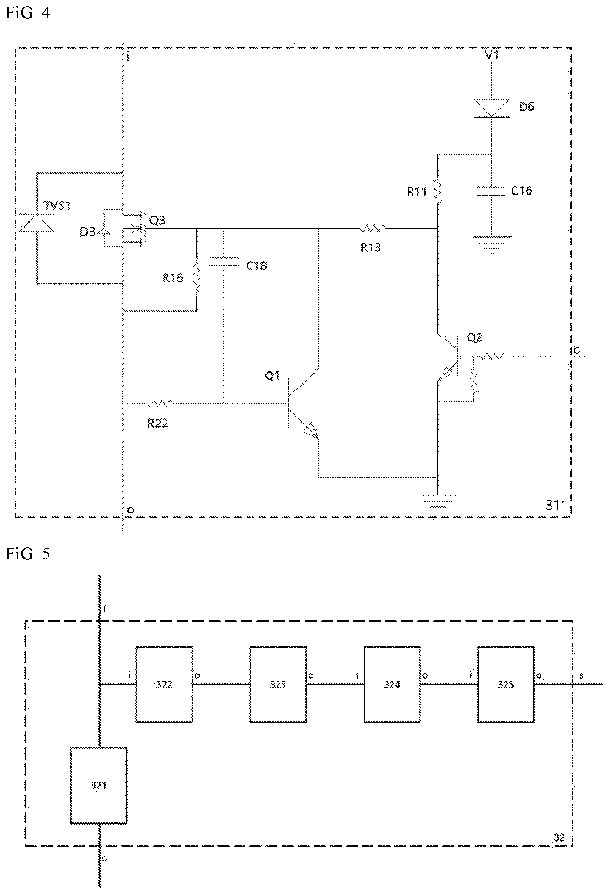

In this embodiment, the state information acquisition module 32 is configured to include a sampling circuit. Referring to FIG. 4 to FIG. 5, the sampling circuit is configured to detect a characteristic value of a current flowing through the boundary line loop. In this embodiment, the control unit 312 controls the electronic switch to be turned on, and if a current is generated in the boundary line loop, the sampling circuit detects a characteristic value of the current in the boundary line loop, and the control unit 312 determines that the boundary line loop is in an on state; if no current is generated in the boundary line loop, the sampling circuit cannot detect the characteristic value of the current in the boundary line loop, and the control unit 312 determines that the boundary line loop is in an open state.

A first terminal of the boundary line 30 is connected with an external power supply Vin, a second terminal of the boundary line 30 is connected with an input terminal 311i of the switch module, a control terminal 311c of the switch module is connected with the control unit 312, an output terminal 311o of the switch module is connected with an input terminal 32i of the sampling circuit, a signal terminal 32s of the sampling circuit is connected with the control unit 312, and an output terminal 32o of the sampling circuit is grounded.

In this embodiment, the sampling circuit includes: a current sampling resistor 321, a first terminal of the current sampling resistor 321 being connected with the input terminal 32i of the sampling circuit, and a second terminal of the current sampling resistor 321 being grounded. For example, the current sampling resistor 321 is configured to be composed of at least two resistors connected in parallel. The sampling circuit further includes a first filter 324, an input terminal 324i of the first filter being connected with the first terminal of the current sampling resistor 321, and an output terminal 324o of the first filter being connected with the control unit 312; wherein the first filter includes an RC filter and a diode D10, the RC filter being connected in parallel with the diode D10. For example, the sampling circuit further includes a follower unit 325, an input terminal 325i of the follower unit being connected with the output terminal 324o of the first filter, and an output terminal 325o of the follower unit being connected with the control unit 312. For the convenience of AD sampling, the sampling circuit further includes an amplifier 323, the first terminal of the current sampling resistor 321 being connected with the input terminal 324i of the first filter through the amplifier 323. For example, the sampling circuit further includes a second filter 322, the first terminal of the current sampling resistor 321 being connected with an input terminal 323i of the amplifier through the second filter 322.

By using the signal control circuit according to the above embodiments, the state information of the boundary line loop is obtained through the sampling circuit, and when the boundary line is disconnected, the control module can control the on-off frequency of the switch circuit to be changed from a high frequency to a low frequency if the control module cannot detect a boundary signal, such that the probability that the switch module is just in an on state when the boundary line loop is connected is reduced, thereby reducing the probability of arc generation.

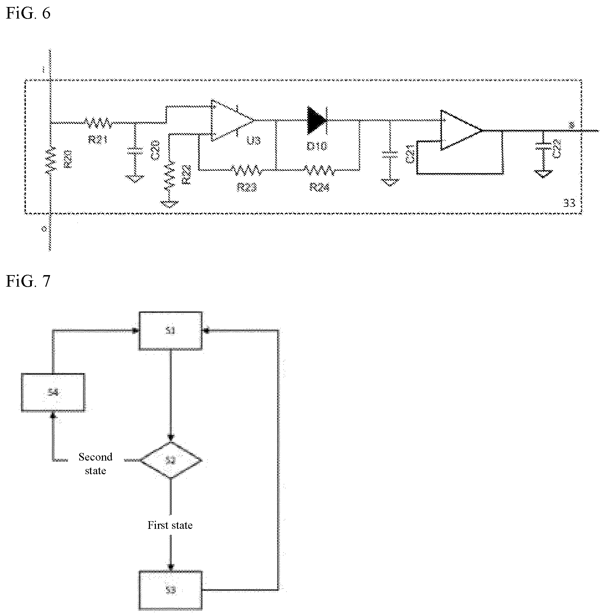

FIG. 7 is a flowchart of a signal control method according to an embodiment of the present disclosure. Referring to FIG. 7, the signal control method according to an embodiment of the present disclosure includes the following steps.

In S1, a characteristic value of a current in a boundary line loop is obtained.

Specifically, the state information acquisition module samples the boundary line current. In this embodiment, when the power is turned on, the control module defaults to control the generation of a pulse with a first frequency in the boundary line loop. In other embodiments, when the power is turned on, the control module may default to control the generation of a pulse with a second frequency in the boundary line loop.

In S2, a state of the boundary line loop is determined according to a characteristic value of a current in the boundary line loop; if the boundary line loop is in a first state, S3 is executed; if the boundary line loop is in a second state, S4 is executed. Specifically, when the electronic switch is turned on or within a preset time period after the electronic switch is turned on, the state information acquisition module detects a sampling current of the boundary line, and then the boundary line loop is determined to be in a first state; when the electronic switch is turned on or within a preset time period after the electronic switch is turned on, the state information acquisition module does not detect the sampling current of the boundary line, the boundary line loop is determined to be in a second state. The first state is an on state, and the second state is an open state.

In S3, the generation of a pulse with a first frequency in the boundary line loop is controlled.

Specifically, when the boundary line loop is in the first state, the control module controls the generation of a pulse with a first frequency in the boundary line loop. For example, the first frequency is not less than 50 Hz. In this embodiment, the first frequency is 60 Hz to 100 Hz; further, the first frequency is 60 Hz to 70 Hz.

In S4, the generation of a pulse with a second frequency in the boundary line loop is controlled, wherein the second frequency is less than the first frequency.

Specifically, when the boundary line loop is in the second state, the control module controls the generation of a pulse with a second frequency in the boundary line loop. For example, the second frequency is less than 50 Hz. In this embodiment, the second frequency is 0.3 Hz to 30 Hz; further, the second frequency is 0.5 Hz to 1.5 Hz.

It should be noted that the above descriptions are only preferred embodiments of the present disclosure and the principles of the employed technologies. It should be understood by those skilled in the art that the present disclosure is not limited to the particular embodiments described herein, and those skilled in the art can make various obvious changes, rearrangements, and substitutions without departing from the protection scope of the present disclosure. Therefore, although the present disclosure has been described in more detail by the above embodiments, it is not limited to the above embodiments, and may further include other equivalent embodiments without departing from the concept of the present disclosure, and the scope of the present disclosure is determined by the scope of the appended claims.

## Claims

1. A signal control circuit, configured to control the generation of a pulse in a boundary line loop, comprising:
a boundary line; and
a control module, configured to be connected with the boundary line, and to control a frequency of the pulse according to a state of the boundary line loop.

2. The signal control circuit according to claim 1, further comprising a state information acquisition module configured to be connected with the boundary line to obtain state information of the boundary line loop; wherein the control module is configured to be connected with the state information acquisition module, and to control the frequency of the pulse according to the state information of the boundary line loop.

3. The signal control circuit according to claim 1, wherein when the boundary line loop is in a first state, the control module controls the generation of a pulse with a first frequency in the boundary line loop; when the boundary line loop is in a second state, the control module controls the generation of a pulse with a second frequency in the boundary line loop.

4. The signal control circuit according to claim 3, wherein the first state is an on state, and the second state is an open state; the first frequency is greater than the second frequency.

5. The signal control circuit according to claim 3, wherein the first frequency is not less than 50 Hz; the second frequency is less than 50 Hz.

6. The signal control circuit according to claim 5, wherein the first frequency is 60 Hz to 100 Hz, and the second frequency is 0.3 Hz to 30 Hz.

7. The first frequency according to claim 6 is 60 Hz to 70 Hz, and the second frequency is 0.5 Hz to 1.5 Hz.

8. The signal control circuit according to any one of claims 1 to 7, wherein the control module comprises a switch module and a control unit, the switch module being arranged on the boundary line loop; when the switch module is turned on, the boundary line loop is in the on state; when the switch module is turned off, the boundary line loop is in the open state; the control unit is connected with the switch module and configured to control the on-off of the switch module, and the control unit is configured to control an on-off frequency of the switch module according to the state of the boundary line loop.

9. The signal control circuit according to claim 8, wherein the switch module is configured to comprise an electronic switch, the electronic switch comprising a field effect transistor.

10. The signal control circuit according to claim 9, wherein the switch module further comprises a first switch circuit, and the electronic switch is connected with the control unit through the first switch circuit.

11. The signal control circuit according to claim 10, wherein the first switch circuit comprises a switch unit, a control terminal of the switch unit being connected with the control unit, an input terminal of the switch unit being connected with a power chip, and meanwhile, the input terminal of the switch unit being connected with a control terminal of the electronic switch, and an output terminal of the switch unit being grounded.

12. The signal control circuit according to claim 11, wherein the switch unit comprises a triode Q2; the switch unit is configured to enable the triode Q2 to be in an off state and the electronic switch to be turned on when the control unit sends out a first level signal; and the transistor Q2 to be in the on state and the electronic switch to be turned off when the control unit sends out a second level signal.

13. The signal control circuit according to claim 12, wherein the first level signal is a low level signal, and the second level signal is a high level signal.

14. The signal control circuit according to claim 10, wherein the first switch circuit further comprises a voltage limiting unit, a control terminal of the voltage limiting unit being connected with an output terminal of the electronic switch, an input terminal of the voltage limiting unit being connected with a control terminal of the electronic switch, and an output terminal of the voltage limiting unit being grounded; the voltage limiting unit comprises a triode Q1.

15. The signal control circuit according to claim 10, wherein the first switch circuit further comprises a filter capacitor C18, a first terminal of the filter capacitor C18 being connected with a control terminal of the electronic switch, and a second terminal of the filter capacitor C18 being connected with an output terminal of the electronic switch through a resistor R22.

16. The signal control circuit according to claim 10, wherein the first switch circuit further comprises a voltage reduction unit, an input terminal of the voltage reduction unit being connected with a power chip, and an output terminal of the voltage reduction unit being connected with a control terminal of the electronic switch; the voltage reduction unit comprises a diode D6 and a capacitor C16, a first terminal of the capacitor C16 being connected with a cathode of the diode D6, and a second terminal of the capacitor C16 being grounded.

17. The signal control circuit according to claim 8, wherein the state information acquisition module is configured to comprise a sampling circuit configured to detect a characteristic value of a current flowing through the boundary line loop; wherein, a first terminal of the boundary line is connected with an external power supply, a second terminal of the boundary line is connected with an input terminal of the switch module, a control terminal of the switch module is connected with the control unit, an output terminal of the switch module is connected with an input terminal of the sampling circuit, a signal terminal of the sampling circuit is connected with the control unit, and an output terminal of the sampling circuit is grounded.

18. The signal control circuit according to claim 17, wherein the sampling circuit comprises a current sampling resistor, a first terminal of the current sampling resistor being connected with the input terminal of the sampling circuit, and a second terminal of the current sampling resistor being grounded; the sampling circuit further comprises a first filter, an input terminal of the first filter being connected with the first terminal of the current sampling resistor, and an output terminal of the first filter being connected with the control unit; the sampling circuit further comprises a follower unit, an input terminal of the follower unit being connected with the output terminal of the first filter, and an output terminal of the follower unit being connected with the control unit; the sampling circuit further comprises an amplifier, the first terminal of the current sampling resistor being connected with the input terminal of the first filter through the amplifier; the sampling circuit further comprises a second filter, the first terminal of the current sampling resistor being connected with an input terminal of the amplifier through the second filter.

19. A signal control method, comprising:
acquiring a state of a boundary line loop; and
controlling a frequency of a boundary signal according to the state of the boundary line loop.

20. The signal control method according to claim 19, wherein when the boundary line loop is in a first state, the frequency of the boundary signal is controlled to be a first frequency; when the boundary line loop is in a second state, the frequency of the boundary signal is controlled to be a second frequency; the first state is an on state, and the second state is an open state; the first frequency is greater than the second frequency.
